(19) Europäisches Patentamt
European Patent Office
Office européen des brevets

(11) **EP 4 549 966 A1**

(12) **EUROPEAN PATENT APPLICATION**

(43) Date of publication:
**07.05.2025 Bulletin 2025/19**

(21) Application number: **24209336.7**

(22) Date of filing: **29.10.2024**

(51) International Patent Classification (IPC):
*G01R 31/367* [(2019.01)]    *G01R 31/382* [(2019.01)]
*G01R 31/392* [(2019.01)]    *H01M 10/48* [(2006.01)]
*B60L 58/10* [(2019.01)]    *G01R 31/378* [(2019.01)]
*G01R 31/36* [(2020.01)]    *G06F 17/18* [(2006.01)]
*H01M 10/052* [(2010.01)]    *H01M 10/0525* [(2010.01)]

(52) Cooperative Patent Classification (CPC):
**G01R 31/36; B60L 58/10; G01R 31/367;
G01R 31/378; G01R 31/382; G01R 31/392;
H01M 10/48;** G01R 31/389; G06F 17/18;
H01M 10/052; H01M 10/0525

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.10.2023 CN 202311439315**

(71) Applicant: **Volvo Car Corporation
405 31 Göteborg (SE)**

(72) Inventors:
• **SHEN, Bin**
**Shanghai (CN)**

• **HE, Wuliyasu**
**Shanghai (CN)**
• **KE, Peng**
**Shanghai (CN)**
• **ZHU, Xiangyang**
**Shanghai (CN)**
• **ZHANG, Xinming**
**Shanghai (CN)**

(74) Representative: **Maiwald GmbH
Engineering
Elisenhof
Elisenstrasse 3
80335 München (DE)**

(54) **METHOD AND APPARATUS FOR DETECTING LI-PLATING IN A LITHIUM BATTERY**

(57) The present disclosure provides a method, an apparatus and device, and a computer-readable storage medium for detecting Li-plating in a lithium battery. The method for detecting Li-plating in a lithium battery includes: charging and discharging the lithium battery to be detected at a preset current, and collecting correlation parameters of the lithium battery during the charging and discharging; acquiring a current number of charge-discharge cycles of the lithium battery; calculating a plurality of detection scores for detecting whether there is Li-plating in the lithium battery based on the current number of charge-discharge cycles and the correlation parameters; and determining a fused detection score based on the plurality of detection scores, and determining that there is Li-plating in the lithium battery if the fused detection score exceeds a fused detection threshold.

FIG. 1

**EP 4 549 966 A1**

## Description

### CROSS-REFERENCE TO RELATED APPLICATION

This application claims priority to Chinese Application No. 202311439315.1 filed on October 31, 2023.

### TECHNICAL FIELD

The present disclosure relates to a field of battery technology, and more specifically, to a method, an apparatus and device, and a computer-readable storage medium for detecting Li-plating in a lithium battery.

### BACKGROUND

With the increasingly severe global environmental and energy issues, new energy vehicles are receiving widespread attention due to their advantages of energy saving, high efficiency, low carbon, environmentally friendly, and the like. In recent years, the electric vehicle industry, such as pure electric vehicles and hybrid vehicles, has rapidly risen and has become an inevitable trend in the development of the automobile industry. Power batteries are one of core components of new energy vehicles. Lithium batteries have become a mainstream choice of power batteries for new energy vehicles due to their advantages of light weight, small volume, high energy density, high charge-discharge efficiency, and long cycle life, and are also widely used in many other fields except for new energy vehicles such as mobile communication, digital technology, energy storage, and the like.

During charging or use of a lithium battery, due to some exceptional factors, there may occur a lithium plating (Li-plating) phenomenon in which lithium ions detaching from a positive electrode of the battery cannot be uniformly, completely embedded into a negative electrode of the battery, but are partially precipitated in the lithium metallic state to form off-white or white-like lithium dendrites on the surface of the negative electrode. Li-plating may lead to a reduction in the amount of lithium ions available in the lithium battery, which may reduce battery performance and shorten the cycle life of the battery. In addition, as lithium dendrites generated by Li-plating keep growing, the lithium dendrites may puncture a separator between the positive and negative electrodes, so that the positive and negative electrodes are lapped, resulting in micro-short circuit inside the battery and even thermal runaway, thereby causing serious safety accidents such as combustion and explosion of the battery. Thus, Li-plating of lithium batteries must be monitored, which has been a problem since the advent of lithium batteries. Typically, Li-plating detection is achieved by disassembling battery cells, but this method is destructive, inefficient, and unsuitable for large-scale implementation on vehicles. Thus, there is a need for a non-destructive and efficient method for detecting Li-plating.

### SUMMARY

The present disclosure provides a method, an apparatus and device, a computer-readable storage medium, and a computer program product that enable efficient, non-destructive detection of Li-plating in a lithium battery.

According to an aspect of an embodiment of the present disclosure, there is provided a method for detecting Li-plating in a lithium battery, comprising: charging and discharging the lithium battery to be detected at a preset current, and collecting correlation parameters of the lithium battery during the charging and discharging; acquiring a current number of charge-discharge cycles of the lithium battery; calculating a plurality of detection scores for detecting whether there is Li-plating in the lithium battery based on the current number of charge-discharge cycles and the correlation parameters; and determining a fused detection score based on the plurality of detection scores, and determining that there is Li-plating in the lithium battery if the fused detection score exceeds a fused detection threshold.

According to an example of an embodiment of the present disclosure, wherein the correlation parameters comprise a voltage and a battery capacity of the lithium battery during the charging and discharging, and wherein calculating the plurality of detection scores for detecting whether there is Li-plating in the lithium battery based on the current number of charge-discharge cycles and the correlation parameters comprises: determining a differential voltage curve of the lithium battery for the current number of charge-discharge cycles based on the voltage and the battery capacity; extracting a trough capacity value at a predetermined trough of the differential voltage curve; acquiring a plurality of historical trough capacity values at the predetermined trough of differential voltage curves of the lithium battery for a plurality of historical charge-discharge cycles; and determining a first detection score for detecting whether there is Li-plating in the lithium battery based on the trough capacity value of the lithium battery, the plurality of historical trough capacity values, and a first detection threshold corresponding to the current number of charge-discharge cycles.

According to an example of an embodiment of the present disclosure, wherein the first detection threshold corresponding to the current number of charge-discharge cycles is determined by: performing charge-discharge cycles for the current number of charge-discharge cycles on a plurality of test lithium batteries, wherein the plurality of test lithium batteries have same cells as the lithium battery; for each test lithium battery of the plurality of test lithium batteries: determining a differential voltage curve for each charge-discharge cycle of the test lithium battery; extracting a trough capacity value at the predetermined trough of a differential voltage curve for each charge-discharge cycle, to obtain a plurality of trough capacity values of the test lithium battery; calculating a plurality of statistical indicators for the test lithium battery based on the plurality of trough capacity values; integrating the plurality of statistical indicators to generate an integrated statistical indicator for the test lithium battery; and determining the first detection threshold based on the integrated statistical indicator for each test lithium battery of the plurality of test lithium batteries.

According to an example of an embodiment of the present disclosure, wherein determining the first detection score for detecting whether there is Li-plating in the lithium battery based on the trough capacity value of the lithium battery, the plurality of historical trough capacity values, and the first detection threshold corresponding to the current number of charge-discharge cycles comprises: calculating a plurality of statistical indicators for the lithium battery based on the trough capacity value of the lithium battery and the plurality of historical trough capacity values; integrating the plurality of statistical indicators to generate an integrated statistical indicator for the lithium battery; and determining the first detection score based on the integrated statistical indicator for the lithium battery and the first detection threshold.

According to an example of an embodiment of the present disclosure, wherein the plurality of statistical indicators comprises at least one of variance, standard deviation, mean absolute deviation, coefficient of variation, Z-score, correlation coefficient, mean absolute error, and data quantile value.

According to an example of an embodiment of the present disclosure, wherein the correlation parameters comprise a voltage and a battery capacity of the lithium battery during the charging and discharging, and wherein calculating the plurality of detection scores for detecting whether there is Li-plating in the lithium battery based on the current number of charge-discharge cycles and the correlation parameters comprises: determining a differential capacity curve of the lithium battery for the current number of charge-discharge cycles based on the voltage and the battery capacity; acquiring differential capacity curves of the lithium battery for a first charge-discharge cycle and a historical number of charge-discharge cycles other than the first charge-discharge cycle; calculating a difference in areas of predetermined high-voltage sections of the differential capacity curves for the current number of charge-discharge cycles and the first charge-discharge cycle from a horizontal axis of the curves; calculating a historical difference in areas of predetermined high-voltage sections of the differential capacity curves for the historical number of charge-discharge cycles and the first charge-discharge cycle from a horizontal axis of the curves; and determining a second detection score based on the difference in areas, the historical difference in areas, the current number of charge-discharge cycles, the historical number of charge-discharge cycles, and a second detection threshold corresponding to the current number of charge-discharge cycles.

According to an example of an embodiment of the present disclosure, wherein the second detection threshold corresponding to the current number of charge-discharge cycles is determined by: performing charge-discharge cycles for the current number of charge-discharge cycles on a test lithium battery, wherein the test lithium battery has a same cell as the lithium battery; determining a differential capacity curve for each charge-discharge cycle of the test lithium battery; calculating a difference in areas of predetermined high-voltage sections of the differential capacity curve of the test lithium battery for each charge-discharge cycle after the first charge-discharge cycle and the differential capacity curve for the first charge-discharge cycle from a horizontal axis of the curves, to obtain a plurality of area differences; and performing a linear fit to the plurality of area differences and corresponding numbers of charge-discharge cycles to obtain a first fitted curve, and obtaining a first slope and a first intercept of the first fitted curve as the second detection threshold.

According to an example of an embodiment of the present disclosure, wherein determining the second detection score based on the difference in areas, the historical difference in areas, the current number of charge-discharge cycles, the historical number of charge-discharge cycles, and the second detection threshold corresponding to the current number of charge-discharge cycles comprises: determining a first measured slope and a first measured intercept of a first straight line with the current number of charge-discharge cycles and the difference in areas, the historical number of charge-discharge cycles and the historical difference in areas as two points, respectively; determining a first component of the second detection score based on the first measured slope and the first slope of the second detection threshold; determining a second component of the second detection score based on the first measured intercept and the first intercept of the second detection threshold; and determining the second detection score based on the first component of the second detection score and the second component of the second detection score.

According to an example of an embodiment of the present disclosure, According to an example of an embodiment of the present disclosure, wherein the correlation parameters comprise a maximum battery capacity and an internal resistance of the lithium battery at the current number of charge-discharge cycles, and wherein calculating the plurality of detection scores for detecting whether there is Li-plating in the lithium battery based on the current number of charge-discharge cycles and the correlation parameters comprises: acquiring a maximum battery capacity and an internal resistance of the lithium battery at a first charge-discharge cycle; determining a third detection score based on the maximum battery capacity and the internal resistance at the current number of charge-discharge cycles, the maximum battery capacity and the internal resistance at the first charge-discharge cycle, and a third detection threshold corresponding to the current number of charge-discharge cycles.

According to an example of an embodiment of the present disclosure, wherein the third detection threshold corresponding to the current number of charge-discharge cycles is determined by: performing charge-discharge cycles for the current number of charge-discharge cycles on a test lithium battery, wherein the test lithium battery has a same cell as the lithium battery; determining an internal resistance and a maximum battery capacity of the test lithium battery at each charge-discharge cycle to obtain a plurality of internal resistances and a plurality of maximum battery capacities; and performing a linear fit to the plurality of internal resistances and the plurality of maximum battery capacities to obtain a second fitted curve, and obtaining a second slope and a second intercept of the second fitted curve as the third detection threshold.

According to an example of an embodiment of the present disclosure, wherein determining the third detection score based on the maximum battery capacity and the internal resistance at the current number of charge-discharge cycles, the maximum battery capacity and the internal resistance at the first charge-discharge cycle, and the third detection threshold corresponding to the current number of charge-discharge cycles comprises: determining a second measured slope and a second measured intercept of a second straight line with the maximum battery capacity and the internal resistance at the current number of charge-discharge cycles, the maximum battery capacity and the internal resistance at the first charge-discharge cycle as two points, respectively; determining a first component of the third detection score based on the second measured slope and the second slope of the third detection threshold; determining a second component of the third detection score based on the second measured intercept and the second intercept of the third detection threshold; and determining the third detection score based on the first component of the third detection score and the second component of the third detection score.

According to an example of an embodiment of the present disclosure, wherein determining the fused detection score based on the plurality of detection scores comprises weighting respective detection scores of the plurality of detection scores to determine the fused detection score, and wherein the fused detection threshold is determined by weighting a plurality of detection thresholds corresponding to the plurality of detection scores.

According to an example of an embodiment of the present disclosure, wherein the lithium battery is a power battery of a vehicle, and acquiring the current number of charge-discharge cycles of the lithium battery comprises: determining the current number of charge-discharge cycles of the lithium battery based on a current total mileage traveled by the vehicle.

According to another aspect of an embodiment of the present disclosure, there is provided an apparatus for detecting Li-plating in a lithium battery, comprising: a charging and discharging unit configured to charge and discharge the lithium battery to be detected at a preset current, and collect correlation parameters of the lithium battery during the charging and discharging; an acquisition unit configured to acquire a current number of charge-discharge cycles of the lithium battery; a detection unit configured to calculate a plurality of detection scores for detecting whether there is Li-plating in the lithium battery based on the current number of charge-discharge cycles and the correlation parameters; and a determination unit configured to determine a fused detection score based on the plurality of detection scores, and determine that there is Li-plating in the lithium battery if the fused detection score exceeds a fused detection threshold.

According to another aspect of an embodiment of the present disclosure, there is provided a device for detecting Li-plating in a lithium battery, comprising: one or more processors; and one or more memories, wherein the memories have stored therein computer-readable instructions which, when executed by the one or more processors, cause the one or more processors to perform the method of any of the above aspects of the present disclosure.

According to another aspect of an embodiment of the present disclosure, there is provided a computer-readable storage medium having stored thereon computer-readable instructions which, when executed by a processor, cause the processor to perform the method of any of the above aspects of the present disclosure.

According to another aspect of an embodiment of the present disclosure, there is provided a computer program product comprising computer-readable instructions, which, when executed by a processor, cause the processor to perform the method of any of the above aspects of the present disclosure.

With the method, the apparatus and device, the computer-readable storage medium, and the computer program product for detecting Li-plating in a lithium battery in the above aspects of the present disclosure, a multi-dimensional Li-plating detection system can be constructed, which enables multi-dimensional feature construction for the lithium battery based on data collected during charge-discharge cycles of the lithium battery to obtain multi-dimensional Li-plating detection scores, and enables fusion of the multi-dimensional Li-plating detection scores to provide a comprehensive evaluation score for Li-plating in the lithium battery, thereby realizing an efficient, non-destructive Li-plating detection for the lithium battery.

BRIEF DESCRIPTION OF DRAWINGS

The above and other objects, features, and advantages of embodiments of the present disclosure will become more apparent from the following detailed description of the embodiments of the present disclosure in conjunction with accompanying drawings. The accompanying drawings are used to provide a further understanding of the embodiments of the present disclosure, constitute a part of the specification, explain the present disclosure together with the embodiments of the present disclosure, and do not constitute a limitation of the present disclosure. In the drawings, like reference numerals generally represent like components or steps.

FIG. 1 illustrates a basic architecture of a Li-plating detection system according to an embodiment of the present disclosure.

FIG. 2 illustrates a flow chart of a Li-plating detection method according to an embodiment of the present disclosure.

FIG. 3 illustrates a plurality of differential voltage curves for a test lithium battery according to an example of an embodiment of the present disclosure.

FIG. 4 illustrates trough capacity values of a plurality of differential voltage curves for a test lithium battery according to an example of an embodiment of the present disclosure.

FIGS. 5A-5H illustrate histograms of variances, standard deviations, mean absolute deviations, coefficients of variation, Z-scores, correlation coefficients, mean absolute errors, and data quantile values, respectively, for trough capacity values of differential voltage curves for a plurality of test lithium batteries according to an example of an embodiment of the present disclosure.

FIG. 6 illustrates histograms of an integrated statistical indicator for the trough capacity values of the differential voltage curves for the plurality of test lithium batteries according to an example of an embodiment of the present disclosure.

FIG. 7 illustrates a plurality of differential capacity curves for a test lithium battery according to an example of an embodiment of the present disclosure.

FIG. 8 illustrates predetermined high-voltage sections of differential capacity curves for a certain subsequent charge-discharge cycle and a first charge-discharge cycle according to an example of an embodiment of the present disclosure.

FIG. 9 illustrates a first fitted curve of a plurality of area differences corresponding to respective numbers of charge-discharge cycles according to an example of an embodiment of the present disclosure.

FIG. 10 illustrates a second fitted curve of a plurality of internal resistances corresponding to respective numbers of charge-discharge cycles according to an example of an embodiment of the present disclosure.

FIG. 11 illustrates a structural schematic diagram of a Li-plating detection apparatus according to an embodiment of the present disclosure.

FIG. 12 illustrates a schematic diagram of an architecture of an exemplary computing device according to an embodiment of the present disclosure.

DETAILED DESCRIPTION

Technical solutions in the embodiments of the present disclosure will be described clearly and thoroughly with reference to the accompanying drawings. Obviously, these described embodiments are only a part of the embodiments of the present disclosure, not all of the embodiments. All other embodiments obtained by those of ordinary skill in the art based on the embodiments in the present disclosure without paying creative efforts fall within the protection scope of the present disclosure.

As used herein and in the claims, the words "a", "an", "one", and/or "the" do not refer to the singular, but may include the plural unless the context clearly dictates otherwise. In general, the terms "comprise" and "include" only imply the inclusion of steps and elements specifically identified, these steps and elements do not constitute an exclusive list and a method or device may also contain other steps or elements.

While the present disclosure makes various references to certain modules in an apparatus according to an embodiment of the present disclosure, any number of different modules may be used and run on a user terminal and/or server. The modules are illustrative only and different aspects of the apparatus and method may use different modules.

Flowcharts are used herein to illustrate steps of a method and an apparatus according to one or more embodiments of the present disclosure. It should be understood that preceding or subsequent steps do not have to be performed exactly in order. Rather, various steps may be processed in reverse order or simultaneously, as desired. Meanwhile, other steps may also be added to the process, or certain step or steps may be removed from the process.

In the embodiments of the present disclosure, a lithium battery generally refers to a battery that consists of a lithium metal or alloy as a positive or negative electrode material and uses a nonaqueous electrolyte solution. For example, common positive electrode materials of a lithium battery may be Lithium Iron Phosphate, Lithium Manganate Oxide, Lithium Cobalt Oxide, Nickel Cobalt Manganese trimetallic material, and the like. In general, a lithium battery may be classified into a lithium-ion battery that does not contain lithium in a metallic state and is generally rechargeable, and a lithium metal battery referring to a battery that employs an elemental lithium metal as an electrode and is generally disposable. In the embodiments of the present disclosure, description is made by taking a lithium-ion battery as an example, but this does not mean that the described features or functions cannot be applied to a lithium metal battery, unless explicitly stated as such or there is a contradiction. In addition, in the embodiments of the present disclosure, description is often made by taking a lithium-ion battery in an electric vehicle as an example, but this does not mean that the described features or functions are used only in the field of electric vehicles, but may be used in any other field of mobile communication, digital technology, etc., involving lithium batteries, unless explicitly stated as such or there is a contradiction. In addition, in the embodiments of the present disclosure, a lithium battery may include one or more lithium cells, and the embodiments of the present disclosure do not limit the number of cells of the lithium battery, and hereinafter, "lithium battery", "lithium cell" may be used interchangeably.

In the embodiments of the present disclosure, the number of charge-discharge cycles refers to the number of cycles for charging and discharging a lithium battery. Herein, one charge-discharge cycle refers to a process of completing one complete discharging and charging of a lithium battery. For example, if a lithium battery currently has 100% charge, discharges it to zero charge, and charges it to 100% charge again, the lithium battery undergoes one charge-discharge cycle and its number of charge-discharge cycles increases by one. The useful life of a lithium battery may be measured in terms of the number of charge-discharge cycles, for example, a conventional lithium battery may have a life of 300 to 500 charge-discharge cycles, 1000 to 1200 charge-discharge cycles, or more. In general, the capacity of a lithium battery decays as the number of charge-discharge cycles increases, thereby affecting the performance of the lithium battery.

When a lithium battery is charged, lithium ions detach from the positive electrode, move toward and embed into the negative electrode; upon discharge, lithium ions detach from the negative electrode, move toward and embed into the positive electrode. During charging or use of the lithium battery, if some abnormal factors occur, there may occur a Li-plating phenomenon, that is, lithium ions detaching from the positive electrode of the battery cannot be uniformly, completely embedded into the negative electrode of the battery, but are partially precipitated in the lithium metallic state to form off-white or white-like lithium dendrites on the surface of the negative electrode. For example, the Li-plating phenomenon may occur when low-temperature charging, high-power charging, overcharging, or when deformation of a battery cell, wrinkling of a battery separator, or reduction of electrolyte, structural damage of a negative electrode, or the like occurs. As described previously, the Li-plating phenomenon may cause a decrease in the life of the battery and may cause serious safety accidents such as combustion and explosion of the battery, and thus the Li-plating phenomenon needs to be monitored. Existing Li-plating detection methods are typically achieved by disassembling battery cells, but such methods are destructive, inefficient, and unsuitable for large-scale implementation on vehicles.

In view of this, the present disclosure provides a multi-dimensional feature fusion method that can achieve efficient, non-destructive Li-plating detection, which performs multi-dimensional feature construction based on data acquired during the charging and discharging of a lithium battery, and establishes a corresponding multi-dimensional feature fusion algorithm, so that comprehensive evaluation of Li-plating in the lithium battery can be achieved based on multi-dimensional features.

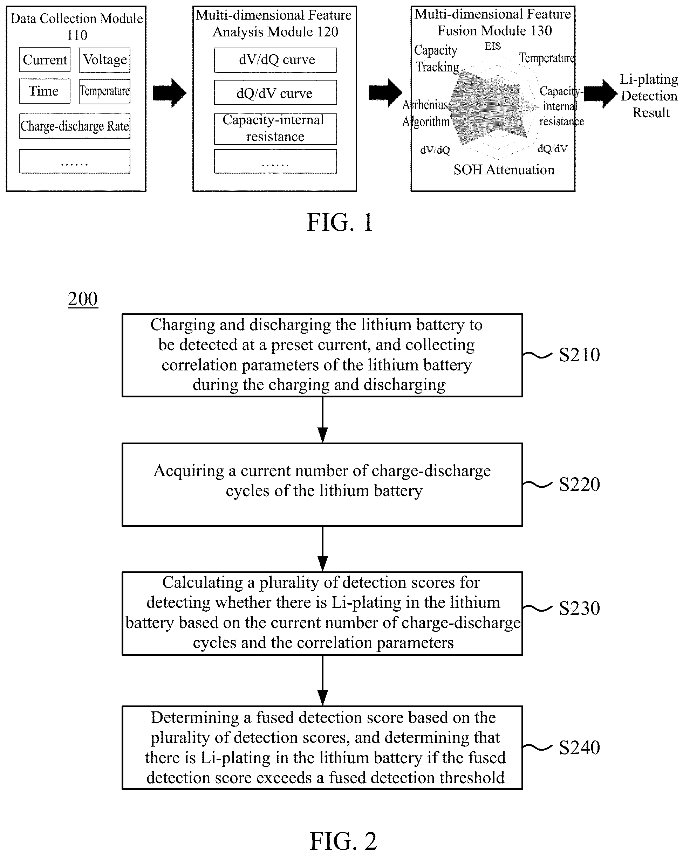

A basic architecture of a Li-plating detection system according to an embodiment of the present disclosure is shown in FIG. 1, which includes a data collection module 110, a multi-dimensional feature analysis module 120, and a multi-dimensional feature fusion module 130. The data collection module 110 is used to collect correlation parameters, such as current, voltage, charge-discharge rate, charge-discharge time, temperature, etc., of a lithium battery to be detected during charge-discharge cycling. The multi-dimensional feature analysis module 120 performs feature construction on the collected correlation parameters from different dimensions, to determine a plurality of detection scores for detecting whether there is Li-plating in the lithium battery. For example, a Li-plating detection method according to an embodiment of the present disclosure may determine a first detection score using a differential voltage curve (dV/dQ) of the lithium battery, a second detection score using a differential capacity curve (dQ/dV) of the lithium battery, a third detection score using a maximum battery capacity and an internal resistance of the lithium battery, and so on, as will be described in further detail below. The Li-plating detection method according to an embodiment of the present disclosure may further determine more detection scores using Electrochemical Impedance Spectroscopy (EIS) of the lithium battery, State of Health (SOH) attenuation of the battery, charge-discharge temperature, capacity tracking algorithm, Arrhenius algorithm, and the like, and the embodiments of the present disclosure do not particularly limit the method of determining the detection scores and the number of the detection scores. The multi-dimensional feature fusion module 130 fuses the plurality of detection scores to determine a fused detection score, and decides whether Li-plating occurred in the lithium battery based on a fused detection threshold set in advance, as will be described in further detail below.

A Li-plating detection method according to an embodiment of the present disclosure will be described below with reference to FIG. 2. FIG. 2 illustrates a flow diagram of a Li-plating detection method 200 according to an embodiment of the present disclosure. As shown in FIG. 2, in step S210, a lithium battery to be detected is charged and discharged at a preset current, and correlation parameters of the lithium battery are collected during the charging and discharging process. Herein, the preset current may be any suitable current value determined according to actual detection requirements or empirical parameters, which is not particularly limited by the embodiments of the present disclosure. When the lithium battery is charged and discharged to acquire the correlation parameters of the lithium battery, the lithium battery may be subjected to one complete charge-discharge cycle, but the embodiments of the present disclosure are not limited thereto, and more or less number of charge-discharge cycles may be performed. For example, in performing Li-plating detection on a lithium battery of an electric vehicle using the Li-plating detection method according to the embodiment of the present disclosure, a current charge of the vehicle may be an arbitrary value, and the lithium battery may be discharged to a zero charge starting from the arbitrary value of the charge, and recharged to a full charge, during which the correlation parameters of the lithium battery are collected, and the number of charge-discharge cycles is less than 1. In addition, the collected correlation parameters of the lithium battery may include voltage, current, charge-discharge rate, charge time, battery capacity, temperature, etc. of the lithium battery during the charging and discharging process, as will be described in further detail below. During charging and discharging of the lithium battery, various parameters related to the lithium battery, such as voltage, current, etc., may be collected at a predetermined collection interval, where the smaller the collection interval, the more correlation parameters of the lithium battery are obtained, thereby providing a more accurate Li-plating detection, but correspondingly, the more correlation parameters will also require more analysis time, resulting in an increased detection time. An appropriate predetermined collection interval may be determined according to actual detection requirements, and specifically, the predetermined collection interval may be determined based on trade-offs on detection accuracy and detection time, for example, may be one collection per second, one collection per minute, or the like, which is not particularly limited by the embodiments of the present disclosure.

In step S220, a current number of charge-discharge cycles of the lithium battery to be detected, that is, the number of charge-discharge cycles the lithium battery has undergone since production, is acquired. For example, the current number of charge-discharge cycles may be determined according to a current capacity of the lithium battery and its design capacity. As previously described, as the number of charge-discharge cycles of the lithium battery increases, the battery capacity gradually decays, and the current number of charge-discharge cycles of the lithium battery may be determined by using the current capacity and the design capacity of the lithium battery according to decay characteristics of the battery capacity. In the case that the lithium battery to be detected is a power battery of a vehicle, the current number of charge-discharge cycles of the lithium battery may also be determined based on a current total mileage traveled by the vehicle, for example, the current number of charge-discharge cycles may be calculated according to the maximum endurance mileage and the current total mileage traveled by the vehicle.

In step S230, a plurality of detection scores for detecting whether there is Li-plating in the lithium battery may be calculated based on the current number of charge-discharge cycles of the lithium battery and the collected correlation parameters. In an embodiment of the present disclosure, the plurality of detection scores may be determined by using different features in the collected correlation parameters to evaluate whether Li-plating has occurred in the lithium battery from a plurality of dimensions. Next, in step S240, a fused detection score may be determined based on the plurality of detection scores, for example, the fused detection score may be determined by weighting respective detection scores of the plurality of detection scores. In the case that the fused detection score exceeds a fused detection threshold, the presence of Li-plating in the lithium battery may be determined. At this time, an alarm message may be generated and output, for example, the alarm message may be sent to a driver of a vehicle containing the lithium battery, to alert the presence of Li-plating in the lithium battery and possible risks.

According to an example of an embodiment of the present disclosure, a differential voltage curve may be constructed using correlation parameters of the lithium battery collected during the charging and discharging process, and a first detection score for detecting Li-plating may be calculated based on characteristics of the differential voltage curve. The differential voltage curve (dV/dQ) refers to a change in voltage per unit capacity during charging and discharging of a lithium battery, and is often used to analyze the performance of the lithium battery. In this example, the collected correlation parameters may include a voltage and a battery capacity of the lithium battery during the charging and discharging process, and a differential voltage curve of the lithium battery at the current number of charge-discharge cycles may be determined based on the voltage and the battery capacity. The differential voltage curve typically has a plurality of peaks and troughs that may reflect to some extent characteristics of the lithium battery. In this example, a capacity value at a predetermined trough (referred to as a trough capacity value) of the differential voltage curve of the lithium battery may be extracted for determining a first detection score for Li-plating detection. The predetermined trough may be, for example, the second trough of the differential voltage curve, which is not particularly limited by the embodiments of the present disclosure, and may be determined according to actual detection requirements and empirical parameters.

Furthermore, a plurality of historical trough capacity values at the predetermined trough of differential voltage curves for a plurality of historical charge-discharge cycles of the lithium battery may be acquired, for use in determining a Li-plating detection score together with the trough capacity value for the current number of charge-discharge cycles of the lithium battery. Taking Li-plating detection for an electric vehicle as an example for explanation, the Li-plating detection method according to the embodiment of the present disclosure may be implemented as a stand-alone Li-plating detection device, or may be integrated as a Li-plating detection assembly in an existing charging device or the electric vehicle body, for example. During each charging and discharging process of the electric vehicle, correlation parameters of the lithium battery may be collected and stored, then when Li-plating detection is currently performed on the lithium battery, these stored historical parameters may be acquired and analyzed to obtain differential voltage curves for a plurality of historical charge-discharge cycles of the lithium battery, and then a plurality of historical trough capacity values at a predetermined trough of these differential voltage curves may be extracted. Next, a first detection score for detecting whether there is Li-plating in the lithium battery may be determined based on the trough capacity value of the lithium battery at the current number of charge-discharge cycles, the acquired plurality of historical trough capacity values, and a first detection threshold corresponding to the current number of charge-discharge cycles.

In this example of the embodiment of the present disclosure, a first detection threshold corresponding to a different number of charge-discharge cycles may, for example, be predetermined, for example, in a Li-plating detection device, or in a charging device or electric vehicle body in which the Li-plating detection assembly is integrated. The predetermined first detection threshold may be determined by performing multiple charge-discharge cycle tests on a plurality of lithium batteries for testing (referred to as test lithium batteries) having the same cell as the lithium battery to be detected, as described below. Note that reference to the "current number of charge-discharge cycles" hereinafter refers to the current number of charge-discharge cycles of the lithium battery to be detected determined above in step S220.

The determination of the first detection threshold corresponding to the current number of charge-discharge cycles of the lithium battery to be detected will be taken as an example for explanation. First, a plurality of test lithium batteries may be subjected to charge-discharge cycling for the current number of charge-discharge cycles. For example, if the current number of charge-discharge cycles of the lithium battery to be detected as determined above is 350, then 350 charge-discharge cycles may be performed separately for each of the test lithium batteries. For each test lithium battery, in each of the charge-discharge cycles, correlation parameters including voltage, capacity, etc. of the test lithium battery may be collected, based on which a differential voltage curve for each charge-discharge cycle may be determined, and a trough capacity value at the predetermined trough of the differential voltage curve may be extracted, so as to obtain a plurality of trough capacity values for each of the plurality of test lithium batteries.

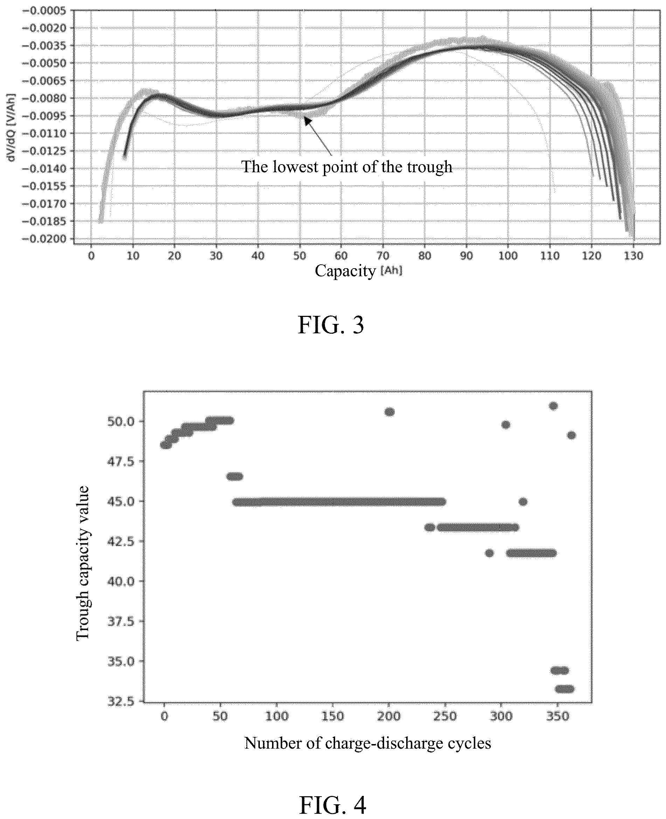

Explanation will be made in connection with an example in FIG. 3, which shows a plurality of differential voltage curves for a test lithium battery according to an example of an embodiment of the present disclosure, where gray curves of different color depths represent differential voltage curves for different charge-discharge cycles, and thicker portions of the curves represent overlapping of the plurality of differential voltage curves. For example, if the current number of charge-discharge cycles is 350, 350 differential voltage curves may be determined. As can be seen from FIG. 3, there is a plurality of troughs in these differential voltage curves, and capacity values at the trough indicated by the arrow in FIG. 3 may be extracted, for example. Then, 350 trough capacity values may be extracted from the 350 differential voltage curves. By plotting these trough capacity values with the number of charge-discharge cycles on the horizontal axis and the trough capacity values on the vertical axis, a scatter plot may be obtained as shown in FIG. 4. It can be seen that the distribution of these trough capacity values is discrete and has no apparent regularity. By further statistically calculating the trough capacity values, a plurality of statistical indicators may be determined, where the plurality of statistical indicators may include, for example, variance, standard deviation, mean absolute deviation, coefficient of variation, Z-score, correlation coefficient, mean absolute error, data quantile value, and any other suitable statistical indicator, which is not particularly limited by the embodiments of the present disclosure.

Li-plating situations of the plurality of test lithium batteries employed in determining the first detection threshold are known, which may be determined, for example, by disassembly inspection of the test lithium batteries. Thereafter, a plurality of statistical indicators, such as variances, standard deviations, and the like, of trough capacity values of the differential voltage curves of the respective test lithium batteries may be respectively determined by the method described above. For each statistical indicator, a detection threshold for deciding whether Li-plating has occurred in a test lithium battery may be determined based on classifying the statistical indicator values of the test lithium batteries, and the reliability of the detection threshold may be analyzed in conjunction with true Li-plating situations of the test lithium batteries.

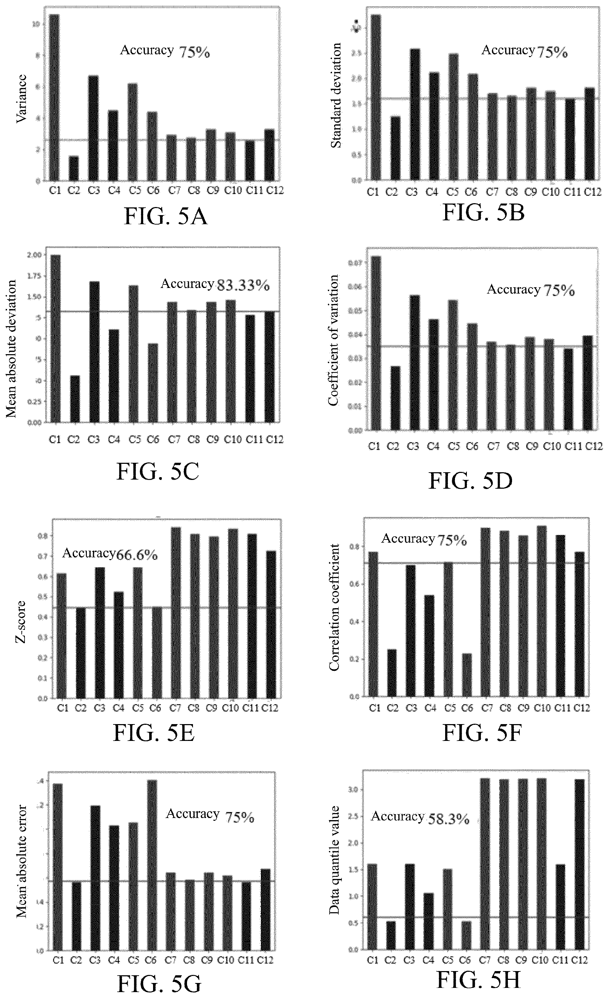

Explanation will be made in connection with examples in FIGS. 5A-5H. FIGS. 5A-5H illustrate histograms of variances, standard deviations, mean absolute deviations, coefficients of variation, Z-scores, correlation coefficients, mean absolute errors, data quantile values, respectively, for trough capacity values of the differential voltage curves for a plurality of test lithium batteries (exemplarily shown as 12 in the figures) according to an example of an embodiment of the present disclosure, in which there is no Li-plating in the test lithium batteries C2, C3, C4, C11, and C12 and there is Li-plating in the remaining test lithium batteries. Taking the variance in Fig. 5A as an example, after variances of the trough capacity values of the 12 test lithium batteries are determined respectively, a histogram in FIG. 5A may be plotted, and a variance detection threshold for deciding whether Li-plating has occurred in the test lithium batteries, as shown by the horizontal straight line in FIG. 5A, may be determined, for example, by classifying the 12 variance values. If the variance of a test lithium battery is greater than the variance detection threshold, it may be considered that there is Li-plating in the test lithium battery; and if the variance of a test lithium battery is less than the variance detection threshold, it may be considered that there is no Li-plating in the test lithium battery. It can be concluded in connection with the true Li-plating situations of the lithium batteries, that the variance detection threshold determined in this way has three errors in deciding whether Li-plating has occurred, i.e., the detection accuracy is 75%. Similarly, the detection accuracies are 75%, 83.33%, 75%, 66.6%, 75%, 75%, and 58.3%, respectively, when using standard deviation, mean absolute deviation, coefficient of variation, Z-score, correlation coefficient, mean absolute error, and data quantile value for detection.

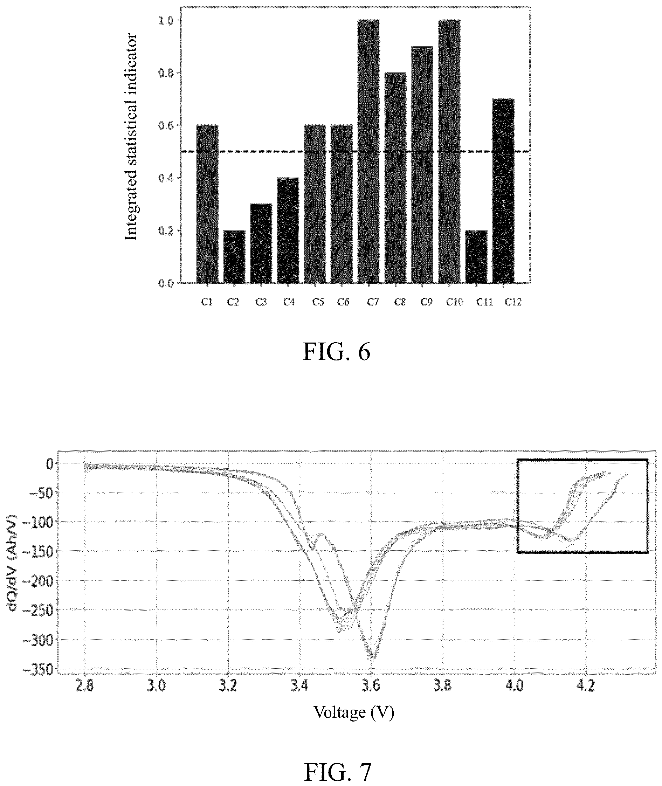

Furthermore, in order to further improve the accuracy of the Li-plating detection, in this example of the embodiment of the present disclosure, the plurality of statistical indicators for each test lithium battery may be integrated to generate an integrated statistical indicator, and the first detection threshold may be determined based on integrated statistical indicators of the respective test lithium batteries. For example, the plurality of statistical indicators for the plurality of test lithium batteries may be integrated using a random forest algorithm to determine the first detection threshold. Random forest algorithm is a type of classification algorithm containing multiple decision trees that can ensemble results of multiple weak classifiers to determine a final classification result that works better. In this example, the eight statistical indicators for each of the test lithium batteries in FIGS. 5A-5H may be integrated using the random forest algorithm to generate integrated statistical indicators, and in turn, to determine the first detection threshold for determining whether there is Li-plating, the result of which is shown in FIG. 6. FIG. 6 illustrates histograms of integrated statistical indicators for the trough capacity values of the differential voltage curves for the plurality of test lithium batteries according to an example of an embodiment of the present disclosure. In FIG. 6, there is no Li-plating in the test lithium batteries C2, C3, C4, C1I, and C12 and there is Li-plating in the remaining test lithium batteries, as described above, and the horizontal straight line represents the determined first detection threshold. It can be seen that when the first detection threshold is used to determine whether Li-plating has occurred, an error occurs only at the lithium battery 12, and the detection accuracy is improved to 91.7%, which is much higher than the detection accuracy using a single statistical indicator as shown in FIGS. 5A-5H. It is to be noted that the random forest algorithm is described above as an example, but the embodiments of the present disclosure are not limited thereto, and any other suitable classification algorithm may be employed.

By using the way as described above, the plurality of statistical indicators for the trough capacity values of the differential voltage curves of the plurality of test lithium batteries at the current number of charge-discharge cycles are integrated, and the first detection threshold for detecting Li-plating corresponding to the current number of charge-discharge cycles is determined based on the integrated statistical indicators. Similarly, a first detection threshold corresponding to a different number of charge-discharge cycles may likewise be determined and stored, e.g., in a Li-plating detection device, or in a charging device or electric vehicle body incorporating the Li-plating detection assembly, for use in a Li-plating detection process for a lithium battery to be detected.

As described above, the first detection score for detecting whether there is Li-plating in the lithium battery to be detected may be determined based on the trough capacity value of the lithium battery at the current number of charge-discharge cycles, the acquired plurality of historical trough capacity values, and the first detection threshold corresponding to the current number of charge-discharge cycles. Specifically, a plurality of statistical indicators, such as a variance, a standard deviation, and the like, for the lithium battery may be calculated based on the trough capacity value of the lithium battery at the current number of charge-discharge cycles and the plurality of historical trough capacity values. The plurality of statistical indicators for the lithium battery may be integrated, for example, by using the random forest algorithm to generate an integrated statistical indicator, and the integrated statistical indicator may be compared with the first detection threshold. Simply, for example, if the integrated statistical indicator for the lithium battery is greater than the first detection threshold, it may be determined that there is Li-plating in the lithium battery; otherwise, it may be determined that there is no Li-plating in the lithium battery. Furthermore, a first detection score for detecting Li-plating may also be determined, based on the integrated statistical indicator for the lithium battery and the first detection threshold, for subsequent multi-dimensional feature fusion. For example, the first detection score may be determined based on a percentage, a relative error, or the like of the integrated statistical indicator for the lithium battery relative to the first detection threshold, which is not particularly limited by the embodiments of the present disclosure.

According to another example of an embodiment of the present disclosure, a differential capacity curve may be constructed using the correlation parameters of the lithium battery collected during the charging and discharging process, and a second detection score for detecting Li-plating may be calculated based on characteristics of the differential capacity curve. The differential capacity curve (dQ/dV) refers to a change in capacity per unit voltage during charging and discharging of a lithium battery, and is often used to analyze the performance of the lithium battery. In this example, the collected correlation parameters may include a voltage and a battery capacity of the lithium battery during the charging and discharging process, and a differential capacity curve of the lithium battery at the current number of charge-discharge cycles may be determined based on the voltage and the battery capacity.

In addition, differential capacity curves of the lithium battery at the first charge-discharge cycle and a historical number of charge-discharge cycles other than the first charge-discharge cycle may be acquired, for use in determining a Li-plating detection score together with the differential capacity curve for the current number of charge-discharge cycles. Taking Li-plating detection for an electric vehicle as an example for explanation, the Li-plating detection method according to the embodiment of the present disclosure may be implemented as a stand-alone Li-plating detection device, or may be integrated as a Li-plating detection assembly in an existing charging device or the electric vehicle body, for example. During each charging and discharging process of the electric vehicle, correlation parameters of the lithium battery may be collected and stored, then when Li-plating detection is currently performed on the lithium battery, these stored historical parameters may be acquired and analyzed to obtain differential capacity curves at the first charge-discharge cycle and a historical number of charge-discharge cycles other than the first charge-discharge cycle of the lithium battery.

Since a high-voltage section of the differential capacity curve can reflect characteristics of the lithium battery to some extent, in this example, high-voltage sections of the differential capacity curves for the current number of charge-discharge cycles, the historical number of charge-discharge cycles, and the first charge-discharge cycle may be extracted. Then, a difference in areas of predetermined high-voltage sections of the differential capacity curves for the current number of charge-discharge cycles and the first charge-discharge cycle from the horizontal axis of the curves, and a historical difference in areas of predetermined high-voltage sections of the differential capacity curves for the historical number of charge-discharge cycles and the first charge-discharge cycle from the horizontal axis of the curves may be calculated. Thereafter, the second detection score for detecting Li-plating may be determined based on the calculated area difference, the historical area difference, and a second detection threshold corresponding to the current number of charge-discharge cycles. The predetermined high-voltage section may be a predetermined portion on a differential capacity curve, such as a portion having a voltage greater than 4V, but the embodiments of the present disclosure are not particularly limited thereto, and the predetermined high-voltage section may be determined according to actual detection requirements and empirical parameters.

In this example of the embodiment of the present disclosure, a second detection threshold corresponding to different numbers of charge-discharge cycles may, for example, be predetermined, for example, in a Li-plating detection device, or in a charging device or electric vehicle body in which the Li-plating detection assembly is integrated. The predetermined second detection threshold may be determined by performing multiple charge-discharge cycle tests on a plurality of test lithium batteries having the same cell as the lithium battery to be detected, as described below.

The determination of the second detection threshold corresponding to the current number of charge-discharge cycles of the lithium battery to be detected is taken as an example for explanation. First, the test lithium batteries may be subjected to charge-discharge cycling for the current number of charge-discharge cycles. For example, if the current number of charge-discharge cycles of the lithium battery to be detected as determined above is 350, the test lithium batteries may be subjected to 350 charge-discharge cycles. At each of these charge-discharge cycles, correlation parameters including voltage, capacity, etc. of the test lithium batteries may be collected, based on which a differential capacity curve for each charge-discharge cycle may be determined, as shown in FIG. 7. FIG. 7 illustrates a plurality of differential capacity curves for a test lithium battery according to an example of an embodiment of the present disclosure, where gray curves of different color depths represent the differential capacity curves for different charge-discharge cycles, and thicker portions of the curves represent overlapping of the plurality of differential capacity curves. In FIG. 7, predetermined high-voltage sections of the differential capacity curves are shown in a black box, here illustrated by a portion of the curves having a voltage greater than 4V as an example.

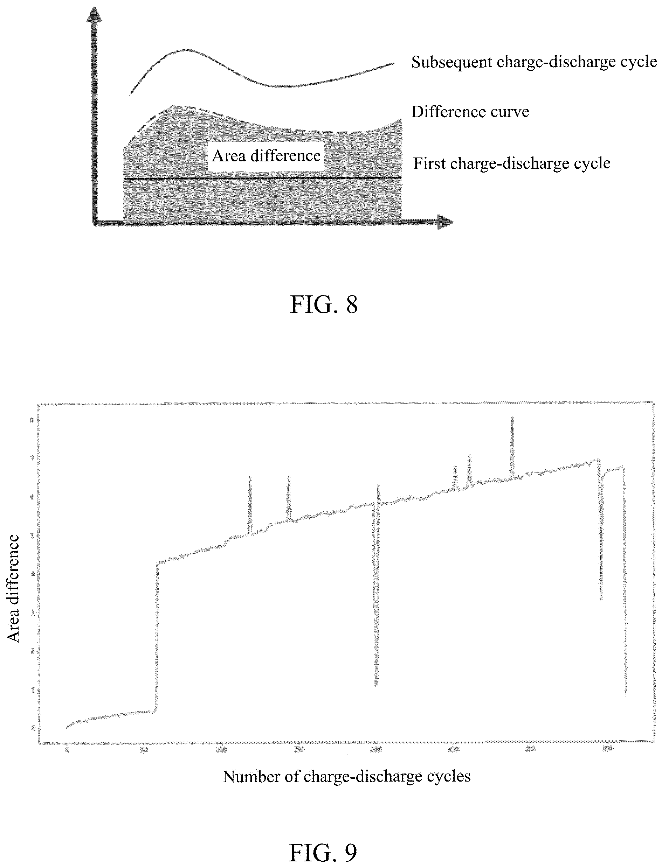

Next, a difference in areas of predetermined high-voltage sections of the differential capacity curve of the test lithium battery for each charge-discharge cycle after the first charge-discharge cycle and the differential capacity curve for the first charge-discharge cycle from the horizontal axis of the curves is calculated, to obtain a plurality of area differences. Explanation will be made in connection with an example in FIG. 8, which illustrates predetermined high-voltage sections of differential capacity curves for a certain subsequent charge-discharge cycle and a first charge-discharge cycle according to an example of an embodiment of the present disclosure. In FIG. 8, the dashed line represents a difference curve of predetermined high-voltage sections of the differential capacity curve for the subsequent charge-discharge cycle and the first charge-discharge cycle, and the area enclosed by the difference curve and the horizontal axis (shown shaded in FIG. 8) is the difference in the areas of the predetermined high-voltage sections of the differential capacity curve for the subsequent charge-discharge cycle and the differential capacity curve for the first charge-discharge cycle from the horizontal axis. Similarly, differences in areas of the predetermined high-voltage sections of differential capacity curves for respective numbers of charge-discharge cycles and the first charge-discharge cycle from the horizontal axis may be determined, thereby obtaining a plurality of area differences. For example, in the case where the current number of charge-discharge cycles of the lithium battery to be detected determined above is 350, 350 differential capacity curves and corresponding 350 area differences may be determined, in which the first charge-discharge cycle corresponds to an area difference of 0. By linearly fitting these area differences and their corresponding numbers of charge-discharge cycles, a first fitted curve as shown in FIG. 9 may be obtained. A first slope and a first intercept of the first fitted curve may be determined as a second detection threshold for detecting Li-plating corresponding to the current number of charge-discharge cycles.

By linearly fitting the differences in areas, from the horizontal axis, of the predetermined high-pressure sections of the differential capacity curve for each number of charge-discharge cycles and the differential capacity curve for the first charge-discharge cycle of the test lithium battery in the way described above, the second detection threshold for detecting Li-plating corresponding to the current number of charge-discharge cycles may be determined. Similarly, a second detection threshold corresponding to a different number of charge-discharge cycles may likewise be determined and stored, for example, in a Li-plating detection device, or in a charging device or electric vehicle body incorporating the Li-plating detection assembly, for use in a Li-plating detection process of the lithium battery to be detected.

As described above, the second detection score for detecting Li-plating may be determined based on the area difference corresponding to the current number of charge-discharge cycles, the historical area difference corresponding to the historical number of charge-discharge cycles, the current number of charge-discharge cycles, the historical number of charge-discharge cycles, and the second detection threshold corresponding to the current number of charge-discharge cycles of the lithium battery to be detected. Specifically, a first measured slope and a first measured intercept of a first straight line may be determined with (the current number of charge-discharge cycles, the area difference), (the historical number of charge-discharge cycles, the historical area difference) as two points, respectively. Simply, for example, if the first measured slope and the first measured intercept are both greater than the first slope and the first intercept of the second detection threshold, it may be determined that there is Li-plating in the lithium battery; otherwise, it may be determined that there is no Li-plating in the lithium battery. Furthermore, a first component of the second detection score may be determined based on the first measured slope and the first slope of the second detection threshold, a second component of the second detection score may be determined based on the first measured intercept and the first intercept of the second detection threshold, and the second detection score for subsequent multi-dimensional feature fusion may be determined based on the first component and the second component of the second detection score. For example, the first component and the second component of the second detection score may be determined based on a percentage, a relative error, or the like of the first measured slope and the first measured intercept of the lithium battery relative to the first slope and the first intercept of the second detection threshold, respectively, and the second detection score may be determined, for example, by averaging, multiplying, or the like the first component and the second component. The way of determining the second detection score and its components is not particularly limited by the embodiments of the present disclosure.

According to another example of an embodiment of the present disclosure, the correlation parameters of the lithium battery to be detected collected during the charging and discharging process may include the maximum battery capacity and internal resistance of the lithium battery at the current number of charge-discharge cycles. The maximum battery capacity refers to the capacity of the lithium battery at full charge, and the maximum battery capacity is different for different numbers of charge-discharge cycles since the battery performance of the lithium battery deteriorates as the number of charge-discharge cycles increases. Methods for measuring the internal resistance of the lithium battery may generally include a direct-current internal resistance measurement method and an alternating-current internal resistance measurement method, and the specific method for measuring the internal resistance is not limited by the embodiments of the present disclosure. Taking the direct-current internal resistance measurement method as an example, the lithium battery to be detected may be subjected to constant current charging or discharging at a predetermined current value for a predetermined period of time, for example, the lithium battery may be subjected to constant current discharging at a predetermined current value I for a predetermined period of time $\Delta T$, then the internal resistance of the lithium battery may be calculated according to the following equation:

$$ R = \frac{U_t - U_{t+\Delta T}}{I}, $$

where $U_t$ represents a voltage value at the start of discharge, and $U_{t+\Delta T}$ represents a voltage value after discharge for $\Delta T$ time. Measurements may be performed at any point in the current charge-discharge cycle in the way described above, to determine the internal resistance of the lithium battery. Ideally, the measurement may be performed at a battery capacity of 50% of the maximum battery capacity, and the discharge time may be, for example, only 10 seconds, but the embodiments of the present disclosure do not particularly limit the time point of the internal resistance measurement and the charge-discharge time, and any other suitable measurement time point and charge-discharge time may be employed.

In addition, the maximum battery capacity and internal resistance of the lithium battery to be detected at the first charge-discharge cycle may be obtained. Taking Li-plating detection for an electric vehicle as an example for explanation, the Li-plating detection method according to the embodiment of the present disclosure may be implemented as a stand-alone Li-plating detection device, or may be integrated as a Li-plating detection assembly in an existing charging device or the electric vehicle body, for example. During each charging and discharging process of the electric vehicle, correlation parameters of the lithium battery may be collected and stored, then when Li-plating detection is currently performed on the lithium battery, these stored historical parameters may be acquired and analyzed to obtain the maximum battery capacity and internal resistance at the first charge-discharge cycle. Thereafter, a third detection score for Li-plating detection may be determined based on the maximum battery capacity and internal resistance for the current number of charge-discharge cycles, the maximum battery capacity and internal resistance for the first charge-discharge cycle, and a third detection threshold corresponding to the current number of charge-discharge cycles.

In this example of the embodiment of the present disclosure, a third detection threshold corresponding to a different number of charge-discharge cycles may, for example, be predetermined, for example, in a Li-plating detection device, or in a charging device or electric vehicle body in which the Li-plating detection assembly is integrated. The predetermined third detection threshold may be determined by performing multiple charge-discharge cycle tests on a test lithium battery having the same cell as the lithium battery to be detected, as described below.

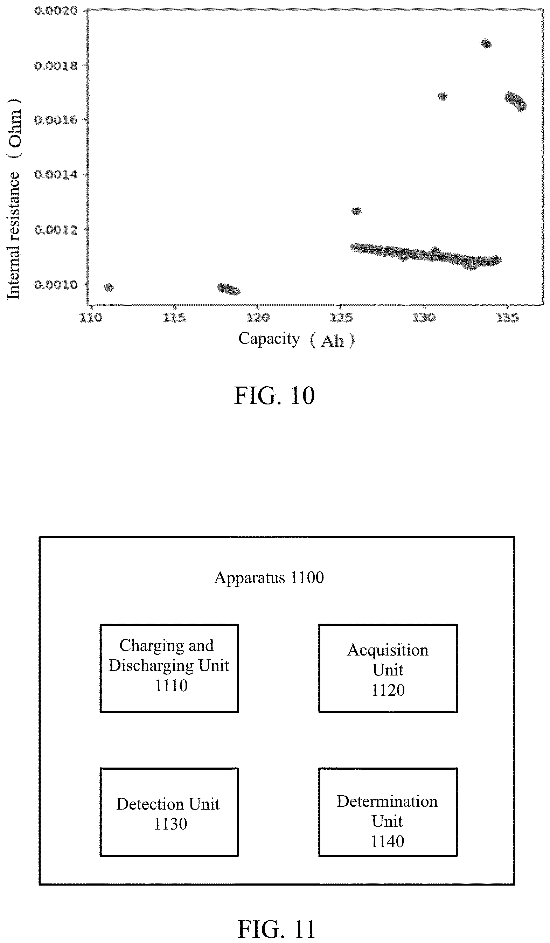

The determination of the third detection threshold corresponding to the current number of charge-discharge cycles of the lithium battery to be detected will be taken as an example for explanation. First, the test lithium battery may be subjected to charge-discharge cycling for the current number of charge-discharge cycles. For example, if the current number of charge-discharge cycles of the lithium battery to be detected as determined above is 350, the test lithium battery may be subjected to 350 charge-discharge cycles. At each of these charge-discharge cycles, the maximum cell capacity and the internal resistance of the test lithium cell may be determined, thereby obtaining a plurality of internal resistances and a plurality of maximum cell capacities. A second fitted curve as shown in FIG. 10 may be obtained by linearly fitting the plurality of internal resistances and the corresponding plurality of maximum cell capacities. A second slope and a second intercept of the second fitted curve may be determined as the third detection threshold for detecting Li-plating corresponding to the current number of charge-discharge cycles.

By linearly fitting the internal resistances and the maximum battery capacities of the test lithium battery for respective numbers of charge-discharge cycles in the way described above, the third detection threshold for detecting Li-plating corresponding to the current number of charge-discharge cycles may be determined. Similarly, a third detection threshold corresponding to a different number of charge-discharge cycles may likewise be determined and stored, for example, in a Li-plating detection device, or in a charging device or electric vehicle body incorporating the Li-plating detection assembly, for use in a Li-plating detection process of the lithium battery to be detected.

As described above, the third detection score for detecting whether there is Li-plating may be determined based on the maximum battery capacity and internal resistance for the current number of charge-discharge cycles, the maximum battery capacity and internal resistance for the first charge-discharge cycle, and the third detection threshold corresponding to the current number of charge-discharge cycles. Specifically, a second measured slope and a second measured intercept of a second straight line may be determined with (the maximum battery capacity for the current number of charge-discharge cycles, the internal resistance for the current number of charge-discharge cycles), (the maximum battery capacity for the first charge-discharge cycle, the internal resistance for the first charge-discharge cycle) as two points, respectively. Simply, for example, if the second measured slope and the second measured intercept are both greater than the second slope and the second intercept of the third detection threshold, it may be determined that there is Li-plating in the lithium battery; otherwise, it may be determined that there is no Li-plating in the lithium battery. Furthermore, a first component of the third detection score may be determined based on the second measured slope and the second slope of the third detection threshold, a second component of the third detection score may be determined based on the second measured intercept and the second intercept of the third detection threshold, and the third detection score for subsequent multi-dimensional feature fusion may be determined based on the first component and the second component of the third detection score. For example, the first component and the second component of the third detection score may be determined based on a percentage, a relative error, etc. of the second measured slope and the second measured intercept of the lithium battery relative to the second slope and the second intercept of the third detection threshold, respectively, and the third detection score may be determined, for example, by averaging, multiplying, etc. the first component and the second component. The way of determining the third detection score and its components is not particularly limited by the embodiments of the present disclosure. In this example, since the time $\Delta T$

required to determine the internal resistance may be short, for example, may be only 10 seconds or less, a faster Li-plating detection may be provided based on the third detection score in this example.

Specific examples of determining the first detection score utilizing the differential voltage curve of the lithium battery to be detected, determining the second detection score utilizing the differential capacity curve of the lithium battery, and determining the third detection score utilizing the maximum battery capacity and the internal resistance of the lithium battery are described above, respectively. In addition, the Li-plating detection method according to an embodiment of the present disclosure may also determine more detection scores by utilizing Electrochemical Impedance Spectroscopy (EIS), State of Health (SOH) attenuation of the battery, charge-discharge temperature, and the like of the lithium battery to be detected, and the embodiments of the present disclosure do not particularly limit the method of determining the detection scores and the number of the detection scores.

After the plurality of detection scores are determined, in step S240, a fused detection score may be determined based on the plurality of detection scores, e.g., the fused detection score may be determined by weighting the respective detection scores of the plurality of detection scores. Afterward, the fused detection score for the lithium battery to be detected at the current charge-discharge cycle may be compared with a corresponding fused detection threshold. In an example of an embodiment of the present disclosure, a fused detection threshold corresponding to a different number of charge-discharge cycles may be, for example, predetermined, for example, in a Li-plating detection device, or in a charging device or electric vehicle body in which the Li-plating detection assembly is integrated. Specifically, the fused detection threshold may be determined by weighting a plurality of detection thresholds corresponding to a plurality of detection scores. For example, the fused detection threshold may be determined by weighted summation of the first detection threshold, the second detection threshold, the third detection threshold, etc. described above. However, the embodiments of the present disclosure are not limited thereto, and any other suitable method may also be employed to determine the fused detection threshold based on the plurality of detection thresholds. If the fused detection score exceeds the fused detection threshold, it may be determined that there is Li-plating in the lithium battery; otherwise, it may be determined that there is no Li-plating in the lithium battery. When it is determined that there is Li-plating in the lithium battery, an alarm message may be generated and output, for example, the alarm message may be sent to a driver of a vehicle containing the lithium battery, to alert the presence of Li-plating in the lithium battery and possible risks.

The method for detecting Li-plating in a lithium battery according to an embodiment of the present disclosure is described above. With the method for detecting Li-plating in a lithium battery according to the embodiment of the present disclosure, a multi-dimensional Li-plating detection system for a lithium battery can be constructed, which enables multi-dimensional feature construction for the lithium battery based on data collected during charge-discharge cycles of the lithium battery to obtain multi-dimensional Li-plating detection scores, and enables fusion of the multi-dimensional Li-plating detection scores to provide a comprehensive evaluation score for Li-plating in the lithium battery, thereby realizing an efficient, non-destructive Li-plating detection for the lithium battery. Furthermore, a user may also be provided with different detection options depending on actual Li-plating detection requirements. For example, if the user wishes to obtain a more accurate Li-plating detection result and does not make much requirements on the detection time, the Li-plating detection may be performed based on the first detection score and the second detection score described above. As another example, if the user wishes to obtain a Li-plating detection result quickly, the Li-plating detection may be performed based on the third detection score described above. The method for detecting Li-plating in a lithium battery according to the embodiments of the present disclosure may be applied to a plurality of fields such as electric vehicles, mobile communications, digital technologies, and the like involving lithium batteries. Taking an electric vehicle as an example, the Li-plating detection method according to the embodiment of the present disclosure may be implemented as a stand-alone Li-plating detection device, or may be integrated as a Li-plating detection component in an existing charging device or an electric vehicle body, so that an efficient, non-destructive Li-plating detection can be performed on the vehicle battery every time the electric vehicle is connected to the Li-plating detection device or every time it is charged.

A Li-plating detection apparatus according to an embodiment of the present disclosure will be described below with reference to FIG. 11. FIG. 11 illustrates a structural schematic diagram of a Li-plating detection apparatus 1100 according to an embodiment of the present disclosure. As shown in FIG. 11, the Li-plating detection apparatus may include a charging and discharging unit 1110, an acquisition unit 1120, a detection unit 1130, and a determination unit 1140. In addition to these 4 components, the Li-plating detection apparatus 1100 may further include more components, but since these components are not relevant to the embodiments of the present disclosure, a specific description of the contents thereof is omitted here. Furthermore, details of the function of the Li-plating detection apparatus 1100 are similar to details of the steps of the Li-plating detection method 200 described above with reference to FIG. 2, and thus repeated description of some of the contents is omitted herein for brevity.

The charging and discharging unit 1110 may be configured to charge and discharge a lithium battery to be detected at a preset current, and collect correlation parameters of the lithium battery during the charging and discharging process. Herein, the preset current may be any suitable current value determined according to actual detection requirements or empirical parameters, which is not particularly limited by the embodiments of the present disclosure. When the lithium battery is charged and discharged to acquire the correlation parameters of the lithium battery, the charging and discharging unit 1110 may perform one complete charge-discharge cycle for the lithium battery, but the embodiments of the present disclosure are not limited thereto, and more or less number of charge-discharge cycles may be performed. For example, in performing Li-plating detection on a lithium battery of an electric vehicle using the Li-plating detection method according to the embodiment of the present disclosure, a current charge of the vehicle may be an arbitrary value, and the lithium battery may be discharged to a zero charge starting from the arbitrary value of the charge, and recharged to a full charge, during which the correlation parameters of the lithium battery are collected, and the number of charge-discharge cycles is less than 1. In addition, the collected correlation parameters of the lithium battery may include voltage, current, charge-discharge rate, charge time, battery capacity, temperature, etc. of the lithium battery during the charging and discharging process, as will be described in further detail below.

The acquisition unit 1120 may be configured to acquire a current number of charge-discharge cycles of the lithium battery to be detected, that is, the number of charge-discharge cycles the lithium battery has undergone since production. For example, the acquisition unit 1120 may determine the current number of charge-discharge cycles according to a current capacity of the lithium battery and its design capacity. As previously described, as the number of charge-discharge cycles of the lithium battery increases, the battery capacity gradually decays, and the current number of charge-discharge cycles of the lithium battery may be determined by using the current capacity and the design capacity of the lithium battery according to decay characteristics of the battery capacity. In the case that the lithium battery to be detected is a power battery of a vehicle, the acquisition unit 1120 may also determine the current number of charge-discharge cycles of the lithium battery based on a current total mileage traveled by the vehicle. For example, the acquisition unit 1120 may calculate the current number of charge-discharge cycles according to the maximum endurance mileage and the current total mileage traveled by the vehicle.

The detection unit 1130 may be configured to calculate a plurality of detection scores for detecting whether there is Li-plating in the lithium battery based on the current number of charge-discharge cycles of the lithium battery and the collected correlation parameters. The detection unit 1130 may determine the plurality of detection scores by using different features in the collected correlation parameters to evaluate whether Li-plating has occurred in the lithium battery from a plurality of dimensions, as described above with reference to FIG. 2 to FIG. 10. The determination unit 1140 may be configured to determine a fused detection score based on the plurality of detection scores, for example, the determination unit 1140 may determine the fused detection score by weighting respective detection scores of the plurality of detection scores. In the case that the fused detection score exceeds a fused detection threshold, the determination unit 1140 may determine the presence of Li-plating in the lithium battery. At this time, an alarm message may be generated and output, for example, the alarm message may be sent to a driver of a vehicle containing the lithium battery, to alert the presence of Li-plating in the lithium battery and possible risks.

The apparatus for detecting Li-plating in a lithium battery according to an embodiment of the present disclosure is described above. With the apparatus for detecting Li-plating in a lithium battery according to the embodiment of the present disclosure, a multi-dimensional Li-plating detection system for a lithium battery can be constructed, which enables multi-dimensional feature construction for the lithium battery based on data collected during charge-discharge cycles of the lithium battery to obtain multi-dimensional Li-plating detection scores, and enables fusion of the multi-dimensional Li-plating detection scores to provide a comprehensive evaluation score for Li-plating in the lithium battery, thereby realizing an efficient, non-destructive Li-plating detection for the lithium battery.

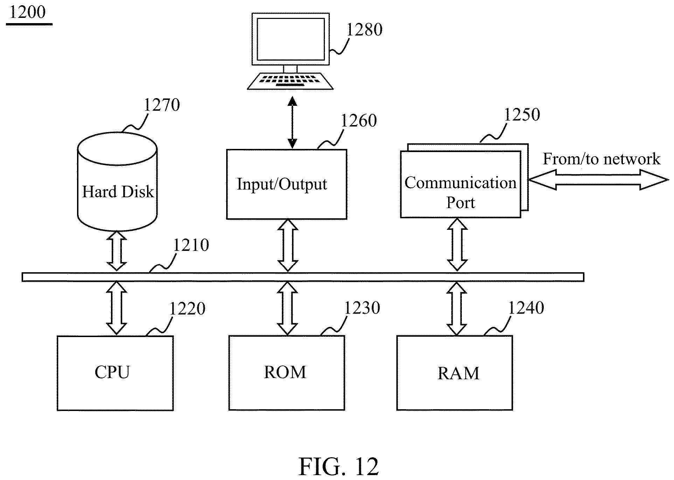

Furthermore, a device according to an embodiment of the present disclosure (e.g., a device for detecting Li-plating in a lithium battery, etc.) may also be implemented by means of an architecture of an exemplary computing device shown in FIG. 12. FIG. 12 illustrates a schematic diagram of an architecture of an exemplary computing device according to an embodiment of the present disclosure. As shown in FIG. 12, the computing device 1200 may include a bus 1210, one or more CPU(s) 1220, a Read Only Memory (ROM) 1230, a Random Access Memory (RAM) 1240, a communication port 1250 connected to a network, an input/output component 1260, a hard disk 1270, and the like. A storage device in the computing device 1200, such as the ROM 1230 or hard disk 1270, may store various data or files used by the device for processing and/or communication, as well as program instructions to be executed by the CPU(s). The computing device 1200 may further include a user interface 1280. Of course, the architecture shown in FIG. 12 is merely exemplary, and one or more components of the computing device shown in FIG. 12 may be omitted as desired in implementing different devices. The device according to the embodiment of the present disclosure may be configured to perform the method for detecting Li-plating in a lithium battery according to the above embodiment of the present disclosure, or for implementing the apparatus for detecting Li-plating in a lithium battery according to the above embodiment of the present disclosure.

The embodiments of the present disclosure may also be implemented as a computer-readable storage medium. A computer-readable storage medium according to an embodiment of the present disclosure has computer-readable instructions stored thereon, which, when executed by a processor, cause the processor to execute the method for detecting Li-plating in a lithium battery according to the embodiment of the present disclosure described with reference to the above drawings. The computer-readable storage medium may include, but is not limited to, volatile memory and/or nonvolatile memory, for example. The volatile memory may include, for example, Random Access Memory (RAM) and/or cache, and the like. The nonvolatile memory may include, for example, a Read-Only Memory (ROM), a hard disk, a flash memory, and the like.

According to an embodiment of the present disclosure, there is also provided a computer program product or computer program including computer-readable instructions stored in a computer-readable storage medium. A processor of a computer device may read the computer-readable instructions from the computer-readable storage medium, and the processor executes the computer-readable instructions, so that the computer device performs the method for detecting Li-plating in a lithium battery in the embodiments described above.

Program portions of the technology may be considered to be "product" or "article" that exists in the form of executable codes and/or related data, which are embodied or implemented by a computer-readable medium. A tangible, permanent storage medium may include an internal memory, or a storage used by computers, processors, or similar devices or associated modules, for example, various semiconductor memories, tape drivers, disk drivers, or any similar devices capable of providing storage functionality for software.

All software or parts of it may sometimes communicate over a network, such as the Internet or other communication networks. Such communication can load software from one computer device or processor to another. Therefore, another medium capable of transmitting software elements can also be used as a physical connection between local devices, such as light waves, electric waves, electromagnetic waves, etc., to be propagated through cables, optical cables, or air. A physical medium used for carrying the waves such as cables, wireless connections, or fiber optic cables may also be considered as a medium for carrying the software. In usage herein, unless a tangible "storage" medium is defined, other terms referring to a computer or machine "readable medium" mean a medium that participates in execution of any instruction by the processor.

The present application uses specific words to describe the embodiments of the present disclosure. Reference to "first/second example" or "another example" means a feature, structure, or characteristic in connection with at least one example of the present application. Therefore, it should be emphasized and noted that two or more references to "an example" or "another example" in various places throughout this specification do not necessarily refer to the same example. Furthermore, certain features, structures, or characteristics may be combined as suitable in one or more examples of the application.

Moreover, one skilled in the art will appreciate that aspects of the present disclosure may be illustrated and described in terms of a number of patentable categories or instances, including any new and useful process, machine, product, or combination of matter, or any new and useful improvement thereof. Accordingly, aspects of the present disclosure may be performed entirely by hardware, entirely by software (including firmware, resident software, micro-code, etc.), or by a combination of hardware and software. The above hardware or software may each be referred to as a "data block", "module", "engine", "unit", "component", or "system." Furthermore, aspects of the present disclosure may be embodied as a computer product embodied in one or more computer-readable media including computer-readable program code.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or extremely formal sense unless expressly so defined herein.

The foregoing is illustrative of the present disclosure and is not to be considered as limiting thereof. Although several exemplary embodiments of the present disclosure have been described, those skilled in the art will readily appreciate that many modifications are possible in the exemplary embodiments without departing from the novel teachings and advantages of the present disclosure. Accordingly, all such modifications are intended to be included within the scope of the present disclosure as defined in the claims. It is to be understood that the above is illustrative of the present disclosure and is not to be considered limited to the specific embodiments disclosed, and that modifications to the disclosed embodiments, as well as other embodiments, are intended to be included within the scope of the appended claims. The present disclosure is defined by the claims and equivalents thereof.

**Claims**

1. A method for detecting Li-plating in a lithium battery, comprising:

charging and discharging (S210) the lithium battery to be detected at a preset current, and collecting correlation parameters of the lithium battery during the charging and discharging; acquiring (S220) a current number of charge-discharge cycles of the lithium battery; calculating (S230) a plurality of detection scores for detecting whether there is Li-plating in the lithium battery based on the current number of charge-discharge cycles and the correlation parameters; and determining (S240) a fused detection score based on the plurality of detection scores, and determining that there is Li-plating in the lithium battery if the fused detection score exceeds a fused detection threshold.

2. The method of claim 1, wherein the correlation parameters comprise a voltage and a battery capacity of the lithium battery during the charging and discharging, and wherein calculating the plurality of detection scores for detecting whether there is Li-plating in the lithium battery based on the current number of charge-discharge cycles and the correlation parameters comprises:

   determining a differential voltage curve of the lithium battery for the current number of charge-discharge cycles based on the voltage and the battery capacity; extracting a trough capacity value at a predetermined trough of the differential voltage curve; acquiring a plurality of historical trough capacity values at the predetermined trough of differential voltage curves of the lithium battery for a plurality of historical charge-discharge cycles; and determining a first detection score for detecting whether there is Li-plating in the lithium battery based on the trough capacity value of the lithium battery, the plurality of historical trough capacity values, and a first detection threshold corresponding to the current number of charge-discharge cycles.

3. The method of claim 2, wherein the first detection threshold corresponding to the current number of charge-discharge cycles is determined by:

   performing charge-discharge cycles for the current number of charge-discharge cycles on a plurality of test lithium batteries, wherein the plurality of test lithium batteries have same cells as the lithium battery; for each test lithium battery of the plurality of test lithium batteries:

      determining a differential voltage curve for each charge-discharge cycle of the test lithium battery; extracting a trough capacity value at the predetermined trough of a differential voltage curve for each charge-discharge cycle, to obtain a plurality of trough capacity values of the test lithium battery; calculating a plurality of statistical indicators for the test lithium battery based on the plurality of trough capacity values; integrating the plurality of statistical indicators to generate an integrated statistical indicator for the test lithium battery; and

   determining the first detection threshold based on the integrated statistical indicator for each test lithium battery of the plurality of test lithium batteries.

4. The method of any of claims 2-3, wherein determining the first detection score for detecting whether there is Li-plating in the lithium battery based on the trough capacity value of the lithium battery, the plurality of historical trough capacity values, and the first detection threshold corresponding to the current number of charge-discharge cycles, comprises:

   calculating a plurality of statistical indicators for the lithium battery based on the trough capacity value of the lithium battery and the plurality of historical trough capacity values; integrating the plurality of statistical indicators to generate an integrated statistical indicator for the lithium battery; and determining the first detection score based on the integrated statistical indicator for the lithium battery and the first detection threshold.

5. The method of any of claims 3-4, wherein the plurality of statistical indicators comprises at least one of variance, standard deviation, mean absolute deviation, coefficient of variation, Z-score, correlation coefficient, mean absolute error, and data quantile value.

6. The method of any of claims 1-5, wherein the correlation parameters comprise a voltage and a battery capacity of the lithium battery during the charging and discharging, and wherein calculating the plurality of detection scores for detecting whether there is Li-plating in the lithium battery based on the current number of charge-discharge cycles and the correlation parameters comprises:

   determining a differential capacity curve of the lithium battery for the current number of charge-discharge cycles based on the voltage and the battery capacity;

acquiring differential capacity curves of the lithium battery for a first charge-discharge cycle and a historical number of charge-discharge cycles other than the first charge-discharge cycle;

calculating a difference in areas of predetermined high-voltage sections of the differential capacity curves for the current number of charge-discharge cycles and the first charge-discharge cycle from a horizontal axis of the curves;

calculating a historical difference in areas of predetermined high-voltage sections of the differential capacity curves for the historical number of charge-discharge cycles and the first charge-discharge cycle from a horizontal axis of the curves; and

determining a second detection score based on the difference in areas, the historical difference in areas, the current number of charge-discharge cycles, the historical number of charge-discharge cycles, and a second detection threshold corresponding to the current number of charge-discharge cycles.

7. The method of claim 6, wherein the second detection threshold corresponding to the current number of charge-discharge cycles is determined by:

performing charge-discharge cycles for the current number of charge-discharge cycles on a test lithium battery, wherein the test lithium battery has a same cell as the lithium battery;

determining a differential capacity curve for each charge-discharge cycle of the test lithium battery;

calculating a difference in areas of predetermined high-voltage sections of the differential capacity curve of the test lithium battery for each charge-discharge cycle after the first charge-discharge cycle and the differential capacity curve for the first charge-discharge cycle from a horizontal axis of the curves, to obtain a plurality of area differences; and

performing a linear fit to the plurality of area differences and corresponding numbers of charge-discharge cycles to obtain a first fitted curve, and obtaining a first slope and a first intercept of the first fitted curve as the second detection threshold.

8. The method of claim 7, wherein determining the second detection score based on the difference in areas, the historical difference in areas, the current number of charge-discharge cycles, the historical number of charge-discharge cycles, and the second detection threshold corresponding to the current number of charge-discharge cycles comprises:

determining a first measured slope and a first measured intercept of a first straight line with the current number of charge-discharge cycles and the difference in areas, the historical number of charge-discharge cycles and the historical difference in areas as two points, respectively;

determining a first component of the second detection score based on the first measured slope and the first slope of the second detection threshold;

determining a second component of the second detection score based on the first measured intercept and the first intercept of the second detection threshold; and

determining the second detection score based on the first component of the second detection score and the second component of the second detection score.

9. The method of any of claims 1-8, wherein the correlation parameters comprise a maximum battery capacity and an internal resistance of the lithium battery at the current number of charge-discharge cycles, and wherein calculating the plurality of detection scores for detecting whether there is Li-plating in the lithium battery based on the current number of charge-discharge cycles and the correlation parameters comprises:

acquiring a maximum battery capacity and an internal resistance of the lithium battery at a first charge-discharge cycle; and

determining a third detection score based on the maximum battery capacity and the internal resistance at the current number of charge-discharge cycles, the maximum battery capacity and the internal resistance at the first charge-discharge cycle, and a third detection threshold corresponding to the current number of charge-discharge cycles.

10. The method of claim 9, wherein the third detection threshold corresponding to the current number of charge-discharge cycles is determined by:

performing charge-discharge cycles for the current number of charge-discharge cycles on a test lithium battery, wherein the test lithium battery has a same cell as the lithium battery;

determining an internal resistance and a maximum battery capacity of the test lithium battery at each charge-discharge cycle to obtain a plurality of internal resistances and a plurality of maximum battery capacities; and

performing a linear fit to the plurality of internal resistances and the plurality of maximum battery capacities to obtain a second fitted curve, and obtaining a second slope and a second intercept of the second fitted curve as the third detection threshold.

11. The method of claim 10, wherein determining the third detection score based on the maximum battery capacity and the internal resistance at the current number of charge-discharge cycles, the maximum battery capacity and the internal resistance at the first charge-discharge cycle, and the third detection threshold corresponding to the current number of charge-discharge cycles comprises:

   determining a second measured slope and a second measured intercept of a second straight line with the maximum battery capacity and the internal resistance at the current number of charge-discharge cycles, the maximum battery capacity and the internal resistance at the first charge-discharge cycle as two points, respectively;
   determining a first component of the third detection score based on the second measured slope and the second slope of the third detection threshold;
   determining a second component of the third detection score based on the second measured intercept and the second intercept of the third detection threshold; and
   determining the third detection score based on the first component of the third detection score and the second component of the third detection score.

12. The method of any of claims 1-11, wherein determining the fused detection score based on the plurality of detection scores comprises weighting respective detection scores of the plurality of detection scores to determine the fused detection score, and wherein the fused detection threshold is determined by weighting a plurality of detection thresholds corresponding to the plurality of detection scores.

13. The method of any of claims 1-11, wherein the lithium battery is a power battery of a vehicle, and acquiring the current number of charge-discharge cycles of the lithium battery comprises:
   determining the current number of charge-discharge cycles of the lithium battery based on a current total mileage traveled by the vehicle.

14. An apparatus (1100) for detecting Li-plating in a lithium battery, comprising:

   a charging and discharging unit (1110) configured to charge and discharge the lithium battery to be detected at a preset current, and collect correlation parameters of the lithium battery during the charging and discharging;

an acquisition unit (1120) configured to acquire a current number of charge-discharge cycles of the lithium battery;
   a detection unit (1130) configured to calculate a plurality of detection scores for detecting whether there is Li-plating in the lithium battery based on the current number of charge-discharge cycles and the correlation parameters; and
   a determination unit (1140) configured to determine a fused detection score based on the plurality of detection scores, and determine that there is Li-plating in the lithium battery if the fused detection score exceeds a fused detection threshold.

15. A device for detecting Li-plating in a lithium battery, comprising:

   one or more processors; and
   one or more memories, wherein the memories have stored therein computer-readable instructions which, when executed by the one or more processors, cause the one or more processors to perform the method of any of claims 1-13.

| Data Collection Module 110 | Multi-dimensional Feature Analysis Module 120 | Multi-dimensional Feature Fusion Module 130 | Li-plating Detection Result |
|---|---|---|---|
| Current / Voltage / Time / Temperature / Charge-discharge Rate / …… | dV/dQ curve / dQ/dV curve / Capacity-internal resistance / …… | Capacity Tracking / EIS / Temperature / Arrhenius Algorithm / Capacity-internal resistance / dV/dQ / dQ/dV / SOH Attenuation | |

FIG. 1

<u>200</u>

Charging and discharging the lithium battery to be detected at a preset current, and collecting correlation parameters of the lithium battery during the charging and discharging — S210

Acquiring a current number of charge-discharge cycles of the lithium battery — S220

Calculating a plurality of detection scores for detecting whether there is Li-plating in the lithium battery based on the current number of charge-discharge cycles and the correlation parameters — S230

Determining a fused detection score based on the plurality of detection scores, and determining that there is Li-plating in the lithium battery if the fused detection score exceeds a fused detection threshold — S240

FIG. 2

FIG. 3

FIG. 4

FIG. 5A

FIG. 5B

FIG. 5C

FIG. 5D

FIG. 5E

FIG. 5F

FIG. 5G

FIG. 5H

FIG. 6

FIG. 7

Subsequent charge-discharge cycle

Difference curve

Area difference

First charge-discharge cycle

FIG. 8

Area difference

Number of charge-discharge cycles

FIG. 9

FIG. 10

FIG. 11

1200

1280

1270

Hard Disk

1260

Input/Output

1250

Communication Port

From/to network

1210

1220

CPU

1230

ROM

1240

RAM

FIG. 12

**EP 4 549 966 A1**

| | Europäisches Patentamt European Patent Office Office européen des brevets | **EUROPEAN SEARCH REPORT** | **Application Number** EP 24 20 9336 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 184 188 A1 (HUAWEI TECH CO LTD [CN]) 24 May 2023 (2023-05-24) | 1,12-15 | INV. G01R31/367 |
| A | * figures 1-7, 9 * <br> * paragraph [0006] * <br> * paragraph [0084] - paragraph [0088] * <br> * paragraphs [0099], [0120] * <br> * paragraph [0165] - paragraph [0168] * <br> * paragraph [0171] - paragraph [0176] * <br> - - - - - | 2-11 | G01R31/382 <br> G01R31/392 <br> H01M10/48 <br> B60L58/10 <br> G01R31/378 <br> G01R31/36 <br> G06F17/18 |
| A | US 2019/113577 A1 (SEVERSON KRISTEN ANN [US] ET AL) 18 April 2019 (2019-04-18) <br> * claim 1; figures 1-23 * <br> * paragraph [0007] - paragraph [0035] * <br> * paragraph [0041] - paragraph [0114] * <br> - - - - - | 1-15 | H01M10/052 <br> H01M10/0525 |
| A | US 2017/203654 A1 (HE CHUAN [US] ET AL) 20 July 2017 (2017-07-20) <br> * figures 1-3, 6 * <br> * paragraph [0014] - paragraph [0030] * <br> * paragraph [0039] - paragraph [0043] * <br> - - - - - | 1-15 | |

**TECHNICAL FIELDS SEARCHED (IPC)**

G01R
G06F
H01M
B60L

The present search report has been drawn up for all claims

| Place of search | Date of completion of the search | Examiner |
|---|---|---|
| Munich | 21 March 2025 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 9336

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2025

| Patent document cited in search report | | Publication date | Patent family member(s) | | Publication date |
|---|---|---|---|---|---|
| EP 4184188 | A1 | 24-05-2023 | CN | 112703125 A | 23-04-2021 |
| | | | EP | 4184188 A1 | 24-05-2023 |
| | | | WO | 2022032460 A1 | 17-02-2022 |
| US 2019113577 | A1 | 18-04-2019 | CN | 110058165 A | 26-07-2019 |
| | | | JP | 7317484 B2 | 31-07-2023 |
| | | | JP | 2019113524 A | 11-07-2019 |
| | | | US | 2019113577 A1 | 18-04-2019 |
| US 2017203654 | A1 | 20-07-2017 | CN | 106985684 A | 28-07-2017 |
| | | | DE | 102017100220 A1 | 20-07-2017 |
| | | | US | 2017203654 A1 | 20-07-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311439315